# EUROPÄISCHE PATENTSCHRIFT

(11) **EP 0 462 108 B1**
(45) Veröffentlichungstag und Bekanntmachung des Hinweises auf die Patenterteilung: **23.03.1994**
(21) Anmeldenummer: 90901539.8
(22) Anmeldetag: 18.01.1990
(51) Int. Cl.: H01L 27/02

(54) **SCHUTZSCHALTUNG GEGEN ÜBERSPANNUNG FÜR MOS-BAUELEMENTE**
OVERVOLTAGE PROTECTION CIRCUIT FOR MOS COMPONENTS
CIRCUIT DE PROTECTION CONTRE LES SURTENSIONS POUR COMPOSANTS MOS

(30) Priorität: 08.03.1989 DE 3907523
(43) Veröffentlichungstag der Anmeldung: 27.12.1991
(73) Patentinhaber: SIEMENS AKTIENGESELLSCHAFT, 80333 München (DE)
(72) Erfinder: TERLETZKI, Hartmud, W-8012 Ottobrunn (DE); RISCH, Lothar, Dr, W-8014 Neubiberg (DE)
(86) Internationale Anmeldenummer: DE9000027
(87) Internationale Veröffentlichungsnummer: WO9010952

(56) Entgegenhaltungen:
- EP-A- 0 043 284
- EP-A- 0 217 525
- ANNUAL PROCEEDINGS RELIABILITY PHYSICS vol. 24, April 1986, Anaheim, California, USA (IEEE Soc.), pages 199-205 ; C. DUVVURY et al. : "ESD PROTECTION RELIABILITY IN 1uM CMOS TECHNOLOGIES", see page 200.
- ANNUAL PROCEEDINGS RELIABILITY PHYSICS vol. 24, April 1986, Anaheom, California, USA (IEEE Soc.), pages 206-214 ; L.F. DECHIARO et al. : "INPUT ESD PROTECTION NETWORKS FOR FINELINE NMOS-EFFECTS OF STRESSING WAVEFORM AND CIRCUIT LAYOUT", see page 206.

## Beschreibung

Die Erfindung betrifft eine Schutzschaltung gegen Überspannungen für MOS-Bauelemente nach dem Oberbegriff des Patentanspruches 1.

Heutige MOS-Bauelemente weisen bei der Fertigung und beim Umgang mit ihnen eine hohe Ausfallrate aufgrund von elektrostatischen Entladungen von Mensch und Maschine auf. Zur Verringerung negativer Auswirkungen dieser elektrostatischen Entladungen, kurz auch ESD (= electrostatic discharge) genannt, gibt es prinzipiell zwei Möglichkeiten. Zum einen kann man für eine potentialfreie Umgebung des MOS-Bauelements sorgen, beispielsweise durch einen Transport desselbigen in speziellen Schaumstoffkörpern oder man entwickelt eine spezielle Schaltung zum Bausteinschutz, die auch auf dem MOS-Bauelement integriert werden kann. Solche Schaltungen schützen dann die empfindlichen Gates der Eingangsstufen der MOS-Bauelemente vor gefährlichen Überspannungen. Ohne einen solchen Bausteinschutz können bereits Spannungen von 20 Volt aufwärts zur Zerstörung des MOS-Bauelements führen, während mit einem Bausteinschutz einige tausend Volt hierfür notwendig werden.

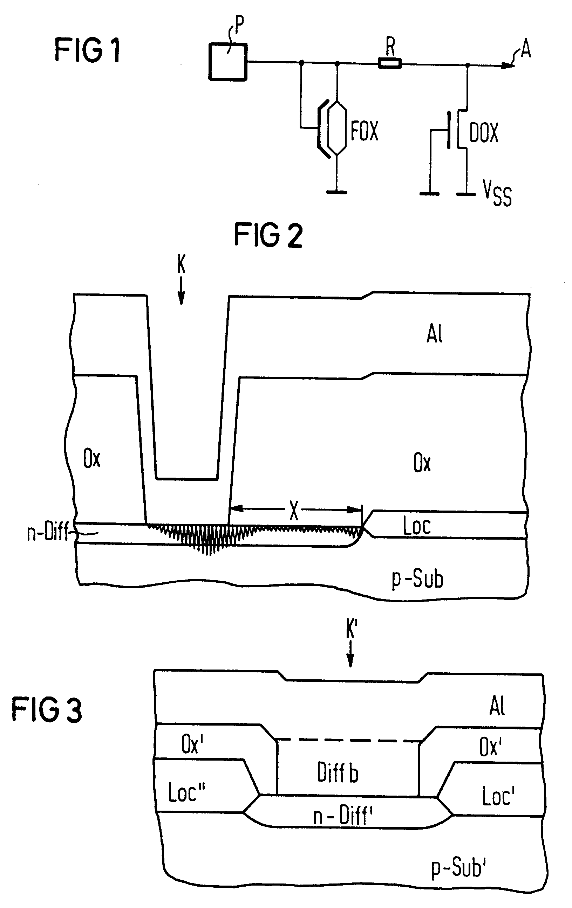

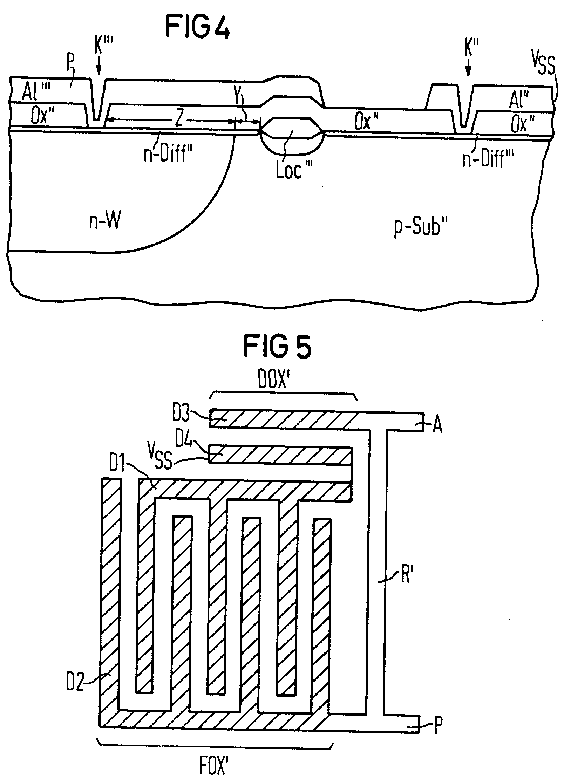

Aus der Veröffentlichung C. Duvvury et al, "ESD Protection Reliability in 1 µm CMOS Technologies", annual, Proc. Reliability Physics Band 24, 1986, ist eine aus einem Dünnoxid-, Feldoxidtransistor und einem Widerstand aufgebaute Schutzschaltung bekannt. Wie aus der Figurenbeschreibung zu Figur 4 der genannten Veröffentlichung weiter hervorgeht, fällt dem Feldoxidtransistor hierbei eine primäre Schutzfunktion zu, während der Dünnoxidtransistor und Widerstand eine sekundäre Schutzfunktion erfüllen. Der Feldoxidtransistor arbeitet bei einer ESD-Belastung als ein im Lawinendurchbruch betriebener parasitärer Bipolartransistor und führt die Energie des ESD-Pulses gegen Masse ab. Bei hohen Energie- bzw. Stromdichten können hierbei Temperaturen auftreten, die in der Größenordnung der eutektischen Temperatur (577°C) von Aluminium und Silizium liegen, wobei die Schmelztemperatur von Aluminium 675°C und die von Silizium 1415°C beträgt. Das Aluminium der Leiterbahn legiert dann in das Silizium des Halbleiterkörpers der MOS-Schaltung und verursacht Kurzschlüsse an den n⁺p⁻-Übergängen. Diese als "spiking" bezeichnete Schädigungen führen dann zum Ausfall des MOS-Bauelements. Die negativen Auswirkungen dieser thermischen Schädigung kann für horizontales "spiking" mit Hilfe eines vergrößerten Abstandes des Kontaktloches vom Feldoxidtransistor verringert werden. Mit steigendem Abstand verbessert sich hierbei das ESD-Verhalten des MOS-Bauelements. Dies gilt jedoch nur für entspannte Herstellungsprozesse (zum Beispiel bei einem 2 µm NMOS-Prozeß). Durch Einfügen von Diffusionsbarrieren zwischen den Aluminiumbahnen und den Diffusionsgebieten, läßt sich die ESD-Empfindlichkeit bezüglich vertikalem "spiking" von MOS-Bausteinen verringern. Als Material für diese Diffusionsbarrieren kann beispielsweise Wolfram, Tantalsilizid oder auch Polysilizium herangezogen werden. Dies ist auch aus der Veröffentlichung L. F. DeChiaro, "Input ESD Protection Networks For Fineline NMOS-Effects Of Stressing Waveform And Circuit Layout", Annual. Proc. Realibility Physics, Band 24, 1986, in Figur 1 sowie der zugehörigen Beschreibung zu entnehmen. Zur Durchführung dieser Maßnahmen ist jedoch ein erhöhter Platzbedarf notwendig, der sich bei zunehmender Integration der MOS-Bauelemente als nachteilig herausstellt.

Aus der europäischen Anmeldeschrift EP 0 217 525 ist eine Schutzeinrichtung bekannt, die mit Hilfe eines Feldoxidtransistors am Ausgang einer zu schützenden Schaltung einen Überspannungsschutz bewirkt.

Der Erfindung liegt die Aufgabe zugrunde, eine verbesserte Schutzschaltung gegen Überspannungen für MOS-Bauelemente anzugeben, die möglichst wenig Platz beansprucht und die Überspannung an Eingangs-Anschlüssen sicher gegen ein Bezugspotential ableitet. Weiterhin soll durch die Erfindung das Problem der Ausfälle durch ESD-Belastung bei MOS-Bauelementen reduziert werden.

Diese Aufgaben werden erfindungsgemäß durch die im kennzeichnenden Teil des Patentanspruches 1 angegebenen Merkmale gelöst.

Die mit der Erfindung erzielten Vorteile bestehen insbesondere darin, daß der in der Schutzschaltung des Feldoxidtransistors enthaltene parasitäre Bipolartransistor sicher durchschaltet und so die hohe Energie der Überspannung auf ein Bezugspotential abführt. Schutzmaßnahmen zur Verhinderung thermischer Schädigungen ("spiking") können entfallen, so daß ein kompakterer Aufbau ohne die eingangs genannten Schutzmaßnahmen möglich ist.

Die Patentansprüche 2 bis 7 sind auf eine bevorzugte Ausgestaltung der Schutzschaltung gerichtet, die dort näher erläutert wird.

Die Erfindung wird nachfolgend anhand von Zeichnungen näher beschrieben, es zeigen dabei
- Figur 1: die Schutzschaltung gegen Überspannungen nach dem Stand der Technik, deren prinzipielle Verschaltung auch der erfindungsgemäßen Schutzschaltung zugrundeliegt,
- Figur 2: Querschnitt durch einen Teil eines MOS-Bauelements bei dem durch Überspannungen thermische Schädigungen ("spiking") aufgetreten sind,
- Figur 3: Querschnitt durch einen Teil eines MOS-Bauelements, welches mit zusätzlichen Diffusionsbarrieren ausgestattet ist, um den thermischen Schädigungen vorzubeugen,
- Figur 4: schematische Darstellung des Feldoxidtransistors in der erfindungsgemäßen Schutzschaltung,
- Figur 5: Layout-Beispiel der erfindungsgemaßen Schutzschaltung.

Figur 1 zeigt eine Schutzschaltung gegen Überspannungen nach dem Stand der Technik, deren prinzipielle Verschaltung auch in der erfindungsgemäßen Schutzschaltung zum tragen kommt. Sie enthält einen Feldoxidtransistor FOX, einen Dünnoxidtransistor DOX, sowie einen Widerstand R. Die Verschaltung dieser Komponenten ist dabei so vorzunehmen, daß der Sourceanschluß des Feldoxidtransistors FOX, der Sourceanschluß des Dünnoxidtransistors DOX, sowie der Gateanschluß des Dünnoxidtransistors jeweils mit einem Bezugspotential verschaltet ist. Als Bezugspotential wurde in diesem Falle Masse V_{SS} gewählt. Der Gateanschluß, sowie der Drainanschluß des Feldoxidtransistors FOX ist sowohl mit einem Anschluß des Widerstandes R als auch mit einem Eingangspad P des MOS-Bauelements verschaltet. Der andere Anschluß des Widerstandes R ist an den Drainanschluß des Dünnoxidtransistors DOX sowie an einem Anschlußpunkt A der Schutzschaltung angeschlossen. An diesem Anschlußpunkt A können weitere MOS-Bauelemente angeschlossen werden, er selbst dient dabei als Ein- bzw. Ausgang für das zu schützende MOS-Bauelement.

Der als widerstandsbehaftete Diffusionsbahn im Halbleitersilizium ausführbare Widerstand R bildet gemeinsam mit dem Dünnoxidtransistor DOX, der als feldgesteuerte Diode geschaltet ist, ein RC-Tiefpaßglied. Der Widerstand R des RC-Tiefpaßglieds dient zur Strombegrenzung beim Auftreten der Überspannungen, da der Dünnoxidtransistor DOX keine hohen Energien bei einer Überspannung gegen das Bezugspotential V_{SS} abführen kann. Hierfür wird der Feldoxidtransistor FOX eingesetzt, der bei einer ESD-Belastung als ein im Lawinendurchbruch betriebener parasitärer Bipolartransistor arbeitet und die Energie des ESD-Pulses gegen das Bezugspotential abführt.

Bei hohen Energie- bzw. Stromdichten aufgrund der Überspannung können innerhalb des MOS-Bauelements Temperaturen auftreten, die in der Größenordnung der Schmelztemperatur von Aluminium und Silizium liegen. Figur 2 zeigt einen Querschnitt durch einen Teil eines MOS-Bauelements bei dem aufgrund der Überspannungen thermische Schädigungen, auch "spiking" genannt, aufgetreten sind. Durch diese Temperaturen diffundiert das Silizium des Halbleiterkörpers in das Aluminium der Leiterbahn während gleichzeitig das Aluminium in das Silizium des Halbleiterkörpers legiert. Es kommt zu Kurzschlüssen an den n⁺ p⁻-Übergängen, die zu einem dauerhaften Ausfall des MOS-Bauelements führen können. Nach Figur 2 ist in das p-leitende Halbleitersubstrat p-Sub ein n⁺-dotiertes Diffusionsgebiet n-Diff eingelagert. Um die späteren aktiven Gebiete untereinander elektrisch zu trennen wird mit Hilfe von örtlich gezielten lokalen Oxidationen nach dem LOCOS-Verfahren (local oxidation of silicon) Isolierschichten Loc erzeugt, wobei eine hiervon in Figur 2 dargestellt ist. Oberhalb dieser Isolierschicht Loc und des n⁺-dotierten Diffusionsgebietes n-Diff ist eine Oxidationsschicht Ox angeordnet, die lediglich innerhalb eines Kontaktgebietes K unterbrochen ist. Oberhalb dieser Oxidationsschicht Ox ist eine Aluminiumschicht Al aufgebracht, die als Leiterbahn eingesetzt wird, und die innerhalb des Kontaktgebietes K eine leitende Verbindung zum n⁺-dotierten Diffusionsgebiet n-Diff herstellt. Weiterhin eingezeichnet in Figur 2 sind die thermischen Schädigungen ("spiking") die sich aufgrund der hohen Energie- bzw. Stromdichten bei Überspannungen ergeben. Das Aluminium der Leiterbahn Al legiert in das p-leitende Halbleitersubstrat p-Sub und verursacht Kurzschlüsse an den n⁺p⁻-Übergängen. Diese führen schließlich zu dem Ausfall des MOS-Bauelements. Wie zu erkennen ist ergeben sich hierbei Maxima unterhalb des Kontaktgebietes K sowie im Bereich des angrenzenden Isolationsgebietes Loc. Im letzten Falle handelt es sich um ein sogenanntes vertikales "spiking" während die zweite thermische Schädigung als horizontales "spiking" bezeichnet wird.

Zur Verringerung des horizontalen "spiking" ist es möglich einen vergrößerten Abstand X zwischen dem Kontaktgebiet K und der Isolationsschicht Loc vorzusehen. Mit steigendem Abstand X verbessert sich das ESD-Verhalten von MOS-Bauelementen. Dies gilt jedoch nur für entspannte Prozesse, wie beispielsweise für einen 2 µm NMOS-Prozeß, wobei die kleinste Kanallänge innerhalb der Schaltung 2 µm breit ist. Ziel zukünftiger Entwicklungen für MOS-Bauelemente ist jedoch eine möglichst kleine Kanallänge zu erreichen um die Schaltungen schneller und kleiner zu gestalten. Beispielsweise wird in einem 4-M Speicherbauelement ein 1,0 µm Prozeß eingesetzt.

Figur 3 zeigt den Querschnitt durch einen Teil eines MOS-Bauelements, welches mit zusätzlichen Diffusionsbarrieren ausgerüstet ist um den thermischen Schädigungen insbesondere des vertikalen "spiking" vorzubeugen. Wie aus Figur 3 ersichtlich, ist innerhalb des p-leitenden Halbleitersubstrats p-Sub' ein n⁺-dotiertes Halbleitergebiet n-Dif'' eingelagert. Zu beiden Seiten dieses n⁺-dotierten Halbleitergebiets sind Isolierschichten Loc', Loc'' angeordnet, die wiederum die späteren aktiven Gebiete untereinander elektrisch trennen. Eine Oxidationsschicht Ox' bedeckt wiederum die Isolierschichten Loc', Loc'', sowie Teile der n⁺-dotierten Halbleiterzonen n-Diff'. Unterbrochen wird diese Oxidationsschicht lediglich innerhalb des Kontaktbereichs K', der mit einer Diffusionsbarriere Diffb aufgefüllt wird. Schließlich bildet eine Aluminiumschicht Al', die die Diffusionsbarriere Diffb, sowie die Oxidationsschicht Ox' gleichermaßen abdeckt den Abschluß der gesamten Anordnung. Als Material für die Diffusionsbarrieren kann beispielsweise Wolfram, Tantalsilizid oder auch Polysilizium eingesetzt werden. Das Material sollte leitfähig und niederohmig sein und keine Schottky-Kontakte an den Übergängen ermöglichen. Durch diese Maßnahme verringert sich die ESD-Empfindlichkeit des MOS-Bauelements insbesondere in bezug auf das vertikale "spiking". Nachteilig ist jedoch hierbei, daß immer dann ein zusätzlicher Prozeß erforderlich ist, wenn die Diffusionsbarriere Diffb zwischen der Aluminiumschicht Al' und der n⁺-dotierten Halbleiterzone n-Diff' mit einer nicht im Herstellungsprozeß enthaltenen Substanz aufgebaut werden soll.

Figur 4 zeigt den erfindungswesentlichen Teil der Schutzschaltung gegen Überspannungen, die grundsätzlich wie in Figur 1 aufgebaut ist. Sie enthält einen Feldoxidtransistor, einen Widerstand sowie einen Dünnoxidtransistor. Figur 4 gibt hierbei den Bereich des Feldoxidtransistors wieder, der durch die Isolierschicht Loc''', den beiden n⁺-Diffusionsgebieten n-Diff'', n-Diff''', der Oxidationsschicht Ox'', sowie den Aluminiumschichten Al'', Al''' gebildet wird. Hierbei stellt die n⁺-Diffusionsschicht n-Diff'' das Draingebiet, das n⁺-Diffusionsgebiet n-Diff''' das Sourcegebiet, und die Isolierschicht Loc''', die Oxidationsschicht Ox'' sowie die Aluminiumschicht Al''' den Gatebereich des Feldoxidtransistors dar. Dem p⁺-dotierten Halbleitersubstrat p-Sub'' sind nach der Figur 4 zwei n⁺-dotierte Diffusionsgebiete n-Diff'', n-Diff''' eingelagert, wobei unterhalb des Diffusionsgebietes n-Diff'' eine weitere wannenförmige Halbleiterzone n-W angeordnet ist, die jedoch schwächer dotiert werden soll als die Diffusionsgebiete. Die Oxidationsschicht Ox'', die sich oberhalb der Isolierschicht Loc''' und den Diffusionsgebieten n-Diff'', n-Diff''' befindet, ist jeweils in den Kontaktbereichen K'' und K''' unterbrochen um der Aluminiumschicht Al'' bzw. Al''' eine Kontaktmöglichkeit zum n⁺-dotierten Diffusionsgebiet zu ermöglichen. Die Aluminiumschicht Al''' hat hierbei Kontakt über das Kontaktgebiet K''' mit dem n⁺-dotierten Diffusionsgebiet n-Diff'', während die Aluminiumschicht Al'' über das Kontaktgebiet K'' mit dem n⁺-dotierten Diffusionsgebiet n-Diff''' kontaktiert ist.

Der Feldoxidtransistor der Schutzschaltung arbeitet bei der ESD-Belastung, wie eingangs bereits angegeben, als ein im Lawinendurchbruch betriebener parasitärer npn-Bipolartransistor, wobei man sich den Kollektoranschluß an dem n⁺dotierten Diffusionsgebiet n-Diff'', den Emitteranschluß an dem n⁺-dotierten Diffusionsgebiet n-Diff''' und den Basisanschluß innerhalb des p-leitenden Halbleitersubstrats p-Sub'' vorstellen kann. Durch die nachfolgend beschriebenen Maßnahmen, die wesentlicher Bestandteil der Erfindung sind, wird der parasitäre Bipolartransistor in seinem Durchbruchsverhalten optimiert, so daß die Schutzschaltung die Überspannungen wirksamer gegen ein Bezugspotential abführen kann. Wie in Figur 1 ist der Feldoxidtransistor mit seinem Drainanschluß und seinem Gateanschluß mit dem Eingang P des zu schützenden MOS-Bauelements verbunden, während der Sourceanschluß mit dem Bezugspotential, in diesem Falle Masse V_{SS} zu verschalten ist. Daher ist die Aluminiumschicht Al'' mit V_{SS} und die Aluminiumschicht Al''' mit dem Anschluß P des MOS-Bauelements zu verbinden. Um die Transistorfunktion überhaupt nutzen zu können, sollen die beiden n⁺-dotierten Diffusionsgebiete des Feldoxidtransistors einen minimalen Abstand voneinander haben. Der minimale Abstand wird hierbei durch das Leckstrom- und das Punch-through-Verhalten des Feldoxidtransistors bestimmt. Die Höhe des Leckstroms sollte hierbei 10 µA nicht überschreiten. Maximal wird der Abstand der beiden n⁺-Diffusionsgebiete durch die Einschaltzeit des parasitären Bipolartransistors bestimmt, so daß die Basislänge bzw. die Steglänge des Feldoxidtransistors eine Länge von 1,5 µm nicht überschreiten soll. In diesem Falle ist ein niederohmiger Pfad gegen das Bezugspotential Vₛₛ gewährleistet, so daß die Einschaltzeit des parasitären npn-Bipolartransistors kurz gehalten wird. Ein Teil der als Kollektor für den parasitären Bipolartransistor wirkenden Elektrode wird, wie bereits angegeben, von einer n-Wanne n-W abgedeckt. Diese niedrig dotierten n-Wanne unter dem n⁺-Diffusionsgebiet n-Diff'' ist in seiner Wirkung als Kollektor effektiver als das hochdotierte n⁺-Diffusionsgebiet n-Diff''. Weiterhin wird durch eine Feldimplantation unter dem Locos-Steg Loc''' die Basisdotierung in diesem Gebiet erhöht und als "channel stop" Maßnahme eingesetzt. Dies verhindert, daß ein ungewünschter Ladungsträgertransport zwischen den beiden n⁺-dotierten Diffusionsgebieten n-Diff'' und n-Diff''' stattfinden kann. Die n-Wanne n-W sollte zu dem Locos-Steg Loc''' hin nicht das gesamte n⁺-Diffusionsgebiet n-Diff'' abdecken, da sonst der Lawinendurchbruch erst bei höheren Spannungen erfolgen kann.

Als beispielhafte Angaben für die Dimensionierung der Dotierungshöhe und der Abmessungen können folgende Angabe gesehen werden. Die n⁺-Diffusionsgebiete n-Diff'' sowie n-Diff''' sollten eine Dotierungshöhe von größer als 10²⁰ cm⁻³, die niedrig dotierte n-Wanne n-W hingegen 4 - 5 x 10¹⁶ cm⁻³ aufweisen. Das p-leitende Substrat p-Sub'', des Halbleiterkörpers könnte eine Dotierstoffkonzentration von 2 -3 x 10¹⁵ cm⁻³ haben, während hingegen die erhöhte Basisdotierung unter dem Locos-Steg Loc''' mit einer Dotierungshöhe von 1 x 10¹⁷ cm⁻³ ausgebildet werden könnte. Die n-Wanne nach Figur 4 ist in ihrer Ausbildung 4 µm tief ausgestaltet und ihre Überlappungslänge über den Kontaktbereich K''', der in Figur 4 mit Z bezeichnet wurden, sollte 3 µm nicht unterschreiten. Weiterhin sollte die Überlappungslänge des n⁺-Diffusionsgebietes n-Diff'' über die n-Wanne n-W, die mit dem Bezugszeichen Y wiedergegeben wurde, 0,5 µm nicht unterschreiten. Die Weite des Feldoxidtransistors sollte 200 µm nicht unterschreiten, wobei dieser wie in Figur 5 dargestellt, platzsparend mäanderförmig angeordnet werden kann.

Seine Steglänge sollte zwischen 0,7 und 1,5 µm liegen. Die Feldimplantation unter dem Locos-Steg Loc''', die die Basisdotierung in diesem Gebiet auf eine Dotierungskonzentration von 1 x 10¹⁷ cm⁻³ erhöht sollte eine Tiefe von 1,2 µm besitzen. Zur Dimensionierung der übrigen Bauelemente der Schutzschaltung, wie des Widerstandes R, sowie des Dünnoxidtransistors DOX, die wie in Figur 1 angegeben verschaltet werden, können folgende Angaben gemacht werden. Der Diffusionswiderstand sollte einen Wert von 1 kOhm nicht überschreiten, während der als feldgesteuerte Diode geschaltete Dünnoxidtransistor DOX eine Kanallänge aufweisen sollte, die ungefähr um den Faktor 0,2 größer zu wählen ist, als die minimale Kanallänge des eingesetzten Prozesses. Bei einem beispielhaften 1 µm Prozeß ist somit die Kanallänge mit 1,2 µm zu dimensionieren. Die Kanalweite für diesen Transistor sollte zwischen 40 und 60 µm liegen.

Beide Feldeffekttransistoren der Schutzschaltung können auch als p-Kanaltransistoren ausgebildet werden, hierzu sind lediglich die p- und n-Gebiete zu vertauschen, die grundsätzliche Verschaltung bleibt hiervon unberührt.

Figur 5 zeigt einen Layout-Entwurf der erfindungsgemäßen Schutzschaltung. Er enthält den Diffusionswiderstand R', sowie den Feldoxid- und den Dünnoxidtransistor FOX', DOX'. Der Feldoxidtransistor FOX' ist mäanderförmig ausgebildet und so aufgebaut, wie dies in der Figur 4 beschrieben wurde. Die Kanalweite des Feldoxidtransistors sollte 200 µm nicht unterschreiten, wobei der Kanal selbst aufgrund zweier kammartig ineinander geschobener n⁺-leitender Dotierungszonen gebildet wird. Die erste n⁺-Dotierungszone D1 ist mit der Masse Vₛₛ verbunden, während die zweite n⁺-Dotierungszone D2 mit einem Eingangspad P des zu schützenden MOS-Bauelements in Verbindung steht. Der Diffusions-widerstand R' ist zwischen der zweiten n⁺-Dotierungszone D2 und der als Drainanschluß für den Dünnoxidtransistor DOX' ausgebildeten dritten n⁺-Dotierungszone D3 geschaltet. Letztere ist mit einem Anschluß A verbunden, über den weitere Bauelemente angeschlossen werden können. Die vierte n⁺-Dotierungszone D4, die mit der Masse Vₛₛ und der ersten n⁺-Dotierungszone D1 in Verbindung steht bildet-hierbei den Sourceanschluß des Dünnoxidtransistors. Aus Platzersparnisgründen ist der Dünnoxidtransistor seitlich an den Feldoxidtransistor angeordnet. Seine Kanalweite ist mit 40 bis 60 µm wesentlich kleiner als die des Feldoxidtransistors, so daß dieser nicht mäanderförmig aufgebaut werden muß. Die Verschaltungen der Gateanschlüsse beider Feldeffekttransistoren wurde aus Übersichtlichkeitsgründen hierbei nicht dargestellt.

## Patentansprüche

1. Schutzschaltung gegen Überspannung für MOS-Bauelemente die einen MOS- Feldoxidtransistor (FOX) mit parasitärem Bipolartransistor, einen MOS-Dünnoxidtransistor (DOX) und einen Widerstand (R) enthält, wobei ein erstes Diffusionsgebiet (n-Diff''') ein Sourcegebiet und ein zweites Diffusionsgebiet (n-Diff'') ein Draingebiet bilden und beide Diffusionsgebiete einen zum Substrat (p-Sub'') unterschiedlichen Leitungstyps besitzen, das erste Diffusionsgebiet (n-Diff''') mit einem ersten Anschluß des MOS-Feldoxidtransistors (FOX), das zweite Diffusionsgebiet (n-Diff'') mit einem zweiten Anschluß des MOS-Feldoxidtransistors (FOX) verbunden ist und bei dem der erste Anschluß des MOS-Feldoxidtransistors (FOX), ein erster Anschluß und ein Gateanschluß jeweils des MOS-Dünnoxidtransistors (DOX) mit einem gemeinsamen Bezugspotential verschaltet sind und bei dem ein erster Anschluß des Widerstandes (R), der zweite Anschluß und ein Gateanschluß jeweils des MOS-Feldoxidtransistors (FOX) mit einem Eingangs-Anschluß (P) des MOS-Bauelements verschaltet ist, und ein zweiter Anschluß des Widerstandes (R) mit einem zweiten Anschluß des MOS-Dünnoxidtransistors (DOX) und mit einem Anschlußpunkt (A) der Schutzschaltung verbunden ist, **dadurch gekennzeichnet,** daß der Abstand zwischen dem ersten und zweiten Diffusionsgebiet (n-Diff'', n-Diff''') so gewählt wird, daß er minimal durch eine Leckstromgrenze des MOS-Feldoxidtransistors und maximal durch eine vorgegebene Einschaltzeit des parasitären Bipolartransistors bestimmt wird, daß unter dem zweiten Diffusionsgebiet (n-Diff'') eine wannenförmig ausgebildete Halbleiterzone (n-W) angeordnet ist, die gleichartig und schwächer dotiert ist wie das zweite Diffusionsgebiet (n-Diff'') und daß das zweite Diffusionsgebiet (n-Diff'') die wannenförmig ausgebildete Halbleiterzone (n-W) überlappt.

2. Schutzschaltung gegen Überspannungen nach Anspruch 1, **dadurch gekennzeichnet,** daß der MOS-Dünnoxidtransistor (DOX) und der MOS-Feldoxidtransistor (FOX) als p-Kanal-Transistor ausgebildet ist.

3. Schutzschaltung gegen Überspannungen nach Anspruch 1, **dadurch gekennzeichnet,** daß der MOS-Dünnoxidtransistor (DOX) und der MOS-Feldoxidtransistor (FOX) als n-Kanal-Transistor ausgebildet ist.

4. Schutzschaltung gegen Überspannungen nach einem der Ansprüche 1 bis 3, **dadurch gekennzeichnet,** daß der Widerstand (R) als widerstandsbehaftete Diffusionsbahn realisiert ist.

5. Schutzschaltung gegen Überspannungen nach einem der Ansprüche 1 bis 4, **dadurch gekennzeichnet,** daß der MOS-Feldoxidtransistor (FOX) mit einer erhöhten Basisdotierung ausgebildet ist, um eine Ladungsbewegung zwischen der ersten und zweiten Diffusionsschicht (n-Diff'', n-Diff''') im Normalbetrieb zu unterbinden.

6. Schutzschaltung gegen Überspannungen nach einem der Ansprüche 1 bis 5, **dadurch gekennzeichnet,** daß der MOS-Feldoxidtransistor (FOX) der Schutzschaltung mäanderförmig auf einem Halbleitersubstrat angeordnet ist.

7. Schutzschaltung gegen Überspannungen nach einem der Ansprüche 1 bis 6, **dadurch gekennzeichnet,** daß die Schutzschaltung mit dem MOS-Bauelement auf einem Halbleitersubstrat integriert ist.

## Claims

1. Overvoltage protection circuit for MOS components which contains an MOS field oxide transistor (FOX) with parasitic bipolar transistor, an MOS thin oxide transistor (DOX) and a resistor (R), in which a first diffusion region (n-Diff''') forms a source region and a second diffusion region (n-Diff'') a drain region and both diffusion regions have a different conducting type from the substrate (p-Sub''), the first diffusion region (n-Diff''') is connected to a first terminal of the MOS field oxide transistor (FOX), the second diffusion region (n-Diff'') to a second terminal of the MOS field oxide transistor (FOX), and in which the first terminal of the MOS field oxide transistor (FOX), and a first terminal and a gate terminal each belonging to the MOS thin oxide transistor (DOX) are connected to a common reference potential, and in which a first terminal of the resistor (R), and the second terminal and a gate terminal each belonging to the MOS field oxide transistor (FOX) are connected to an input terminal (P) of the MOS component, and a second terminal of the resistor (R) is connected to a second terminal of the MOS thin oxide transistor (DOX) and to a terminal point (A) of the protection circuit, characterised in that the spacing between the first and second diffusion region (n-Diff''', n-Diff'') is so chosen that its minimum is determined by a leakage current limit of the MOS field oxide transistor and its maximum by a specified switch-on time of the parasitic bipolar transistor, in that a semiconductor zone (n-W) which is of tub-shaped construction and which is similarly and more lightly doped than the second diffusion region (n-Diff'') is disposed beneath the second diffusion region (n-Diff''), and in that the second diffusion region (n-Diff'') overlaps the semiconductor zone (n-W) of tub-shaped construction.

2. Overvoltage protection circuit according to Claim 1, characterised in that the MOS thin oxide transistor (DOX) and the MOS field oxide transistor (FOX) are constructed as p-channel transistor.

3. Overvoltage protection circuit according to Claim 1, characterised in that the MOS thin oxide transistor (DOX) and the MOS field oxide transistor (FOX) are constructed as n-channel transistor.

4. Overvoltage protection circuit according to any of Claims 1 to 3, characterised in that the resistor (R) is constructed as resistive diffusion track.

5. Overvoltage protection circuit according to any of Claims 1 to 4, characterised in that the MOS field oxide transistor (FOX) is constructed with an increased base doping in order to suppress a charge movement between the first and second diffusion layer (n-Diff''', n-Diff'') in normal operation.

6. Overvoltage protection circuit according to any of Claims 1 to 5, characterised in that the MOS field oxide transistor (FOX) of the protection circuit is disposed in a meander fashion on a semiconductor substrate.

7. Overvoltage protection circuit according to any of Claims 1 to 6, characterised in that the protection circuit is integrated with the MOS component on a semiconductor substrate.

## Revendications

1. Circuit de protection contre une surtension pour des modules-MOS, qui comporte un transistor-MOS à oxyde de champ (FOX) à transistors bipolaires parasites, un transistor MOS à couche d'oxyde mince (DOX) et une résistance (R), du type dans lequel une première zone de diffusion (n-Diff''') forme une zone de source et une deuxième zone de diffusion (n-Diff'') forme une zone de drain et les deux zones de diffusion ont un type de conduction différent de celui du substrat (p-Sub''), la première zone de diffusion (n-Diff''') est reliée à une première borne du transistor MOS à oxyde de champ (FOX), la deuxième zone de diffusion (n-DIFF'') est reliée à une deuxième borne du transistor MOS à oxyde de champ (FOX), et dans lequel la première borne du transistor MOS à oxyde de champ (FOX), une première borne et une borne de grille du transistor MOS à couche d'oxyde mince (DOX) sont reliées à un potentiel commun de référence, et dans lequel une première borne de la résistance (R), la deuxième borne et une borne des grilles du transistor MOS à oxyde de champ (FOX) sont reliées à une borne d'entrée (P) du module-MOS, et une deuxième borne de la résistance (R) est reliée à une deuxième borne du transistor MOS à couche d'oxyde mince (DOX) et à un point de raccordement (A) du circuit de protection, caractérisé en ce que la distance entre la première et la deuxième zone de diffusion (n-Diff'', n-Diff''') est choisie de telle sorte qu'elle est déterminée au minimum par une limite de courant de fuite du transistor MOS à oxyde de champ et au maximum par un temps de fonctionnement prédéterminé du transistor bipolaire parasite, qu'en dessous de la deuxième zone de diffusion (n-Diff'') est disposée une zone semiconductrice (n-W) qui est en forme de cuvette et qui est dopée du même type, mais plus fortement que la deuxième zone de diffusion (n-Diff''), et que la deuxième zone de diffusion (n-Diff'') recouvre la zone semiconductrice (n-W) en forme de cuvette.

2. Circuit de protection contre des surtensions suivant la revendication 1, caractérisé en ce que le transistor MOS à couche d'oxyde mince (DOX) et le transistor MOS à oxyde de champ (FOX) sont formés en tant que transistor à canal p.

3. Circuit de protection contre des surtensions suivant la revendication 1, caractérisé en ce que le transistor MOS à couche d'oxyde mince (DOX) et le transistor MOS à oxyde de champ (FOX) sont formés en tant que transistors à canal n.

4. Circuit de protection contre des surtensions suivant l'une des revendications 1 à 3, caractérisé en ce que la résistance (R) est réalisée en tant que voie de diffusion à effet résistif.

5. Circuit de protection contre des surtensions suivant l'une des revendications 1 à 4, caractérisé en ce que le transistor MOS à oxyde de champ (FOX) est réalisé avec un dopage de base élevé, afin d'interdir, en fonctionnement normal, un mouvement de charge entre la première et la deuxième zones de diffusion (n-Diff'', n-Diff''').

6. Circuit de protection contre des surtensions suivant l'une des revendications 1 à 5, caractérisé en ce que le transistor MOS à oxyde de champ (FOX) du circuit de protection est disposé sous forme de méandres, sur un substrat semiconducteur.

7. Circuit de protection contre des surtensions suivant l'une des revendications 1 à 6, caractérisé en ce qu'il est intégré avec le module MOS sur un substrat semiconducteur.
